# EUROPÄISCHE PATENTSCHRIFT

(11) **EP 2 256 927 B1**
(45) Veröffentlichungstag und Bekanntmachung des Hinweises auf die Patenterteilung: **05.09.2018**
(21) Anmeldenummer: 10173357.4
(22) Anmeldetag: 25.07.2005
(51) Int. Cl.: H05B 41/28, H05B 41/282, H02M 3/157, H03K 17/16

(54) **Kalibrierung und Ansteuerung von Leistungsschaltern in einem Betriebsgerät für Leuchtelemente**
Calibration and control of power switches in an operating device for light emitting elements
Etalonnage et commande d'amorçage des interrupteurs dans un équipement d'exploitation pour des éléments lumineux

(30) Priorität: 30.07.2004 DE 102004036958
(43) Veröffentlichungstag der Anmeldung: 01.12.2010
(62) Teilanmeldung aus: 05768655.2
(73) Patentinhaber: Tridonic GmbH & Co KG, 6851 Dornbirn (AT)
(72) Erfinder: Zudrell-Koch, Stefan, 6845, Hohenems (AT); Knoedgen, Horst, 80997, München (DE)
(74) Vertreter: Rupp, Christian

(56) Entgegenhaltungen:
- WO-A1-97/29618
- DE-A1- 4 228 683
- DE-A1- 10 163 032
- DE-C1- 10 137 752
- DE-C1- 19 841 757
- US-A- 4 567 378
- US-A1- 2001 048 294
- US-A1- 2004 090 804
- US-A1- 2004 140 833
- US-B1- 6 194 884

## Beschreibung

Die vorliegende Erfindung bezieht sich allgemein auf das Gebiet der Ansteuerung von Leistungsschaltern, wie sie beispielsweise in einer PFC (Power Factor Control)-Schaltung Verwendung finden können.
Aus der DE 10163032 A1 ist ein elektronisches Vorschaltgerät für eine Gasentladungslampe bekannt.
Aus der DE 10137752 C1 ist eine Vorrichtung zur Ansteuerung eines Schaltelements ein zugehöriges Betriebsverfahren bekannt.
Aus der WO 9729618 ist ein Dimmer für eine Fluoreszenzbeleuchtung bekannt.

Aus dem Stand der Technik ist ferner bereits bekannt, daß ein bestimmter zeitlicher Verlauf, insbesondere im Bereich der Flanken, des Schaltverhaltens eines Leistungsschalters vorteilhaft hinsichtlich einer Verringerung der durch den Schaltvorgang erzeugten elektromagnetischen Störungen (EMI, Electromagnetic Interference) ist.
Die vorliegende Erfindung geht von dieser Erkenntnis aus und hat sich zur Aufgabe gemacht, eine Technik bereitzustellen, mittels der in flexibler Weise auch unterschiedlichen Leistungsschaltern ein gewünschtes Schaltungsverhalten auferlegt werden kann.
Diese Aufgabe wird erfindungsgemäß durch die Merkmale der unabhängigen Ansprüche gelöst. Die abhängigen Ansprüche bilden den zentralen Gedanken der Erfindung in besonders vorteilhafter Weise weiter.

Gemäß einem ersten Aspekt der Erfindung ist ein Verfahren zur geregelten Ansteuerung eines Leistungsschalters eines PFCs eines Betriebsgeräts für Leuchtmittel. Dabei wird zuerst ein Sollverhalten des Stroms und/oder der Spannung durch den bzw. an den Leistungsschalter zumindest für einen zeitlichen Abschnitt eines Schaltvorgangs vorgegeben.

Das tatsächliche Verhalten (Istverhalten) dieses Parameters wird gemessen und zur Bildung einer geschlossenen Regelschleife zurückgeführt. Schließlich wird das gemessene Istverhalten mit dem Sollverhalten verglichen und die Ansteuerung des Leistungsschalters derart bewirkt, daß das Istverhalten im wesentlichen dem Sollverhalten folgt.

Das Sollverhalten kann insbesondere den Flankenverlauf des Schaltvorgangs, beispielsweise anhand wenigstens zweier Stützpunkte vorgeben.

Werte, die das Sollverhalten wiedergeben, können beispielsweise als diskrete Werte in einem Speicher abgelegt sein. Alternativ oder zusätzlich kann das Sollverhalten auch mittels einer analogen Schaltung, beispielsweise mittels eines Rechteck-Oszillators mit begrenzter Flankensteilheit, vorgegeben werden.

Die vorliegende Erfindung bezieht sich gemäß einem weiteren Aspekt auch auf ein Verfahren zur Kalibrierung des Schaltverhaltens eines Leistungsschalters eines PFCs eines Betriebsgeräts für Leuchtmittel. Dabei wird der Strom und/oder die Spannung durch den bzw. an dem Leistungsschalter zumindest für einen zeitlichen Abschnitt eines Schaltvorgangs gemessen. Daraufhin wird die Ansteuerung des Leistungsschalters dahingehend abgeglichen, dass zur Erzielung einer geringen elektromagnetischen Störung während des Schaltverhaltens das tatsächliche Schaltverhalten im Wesentlichen einem vorgegebenen Sollverhalten entspricht, wobei das Sollverhalten hinsichtlich der elektromagnetischen Interferenz (EMI) optimiert ist.

Schließlich bezieht sich die vorliegende Erfindung auch auf eine Leistungsschalter-Regelschaltung. Diese Regelschaltung weist Mittel zur Vorgabe eines Sollverhaltens des Stroms und/der Spannung durch einen bzw. an einem Leistungsschalter zumindest für einen zeitlichen Abschnitt eines Schaltvorgangs auf. Weiterhin sind Mittel zur Messung des Istverhaltens sowie zur Rückführung des Meßergebnisses vorgesehen. Schließlich ist eine Regeleinrichtung vorgesehen, die die Ansteuerung des Leistungsschalters derart ausführt, daß das Istverhalten im wesentlichen dem Sollverhalten entspricht.
Diese Regeleinrichtung kann beispielsweise ein ASIC und/oder eine diskrete Schaltung sein.
Schließlich bezieht sich die vorliegende Erfindung auch auf ein System zur Kalibrierung des Schaltverhaltens eines Leistungsschalters, auf ein Betriebsgerät für Leuchtelemente, auf ein elektronisches Vorschaltgerät (EVG) für Gasentladungslampen sowie auf eine PFC-Schaltung, die jeweils eine derartige Regelschaltung aufweisen.

Weitere Eigenschaften, Vorteile und Merkmale der vorliegenden Erfindung sollen nunmehr bezugnehmend auf die Figuren der beigefügten Zeichnungen näher erläutert werden.
Fig. 1 zeigt dabei eine schematische Übersicht über eine erfindungsgemäße analoge Regelschaltung,
Fig. 2 zeigt eine schematische Übersicht über eine erfindungsgemäße digitale Regelschaltung,
Fig. 3 zeigt eine erfindungsgemäße Kalibrierung einer Ansteuerschaltung, und
Fig. 4 zeigt die Anwendung einer erfindungsgemäßen Regelschaltung im Rahmen einer PFC (Power Factor Correction)-Schaltung.

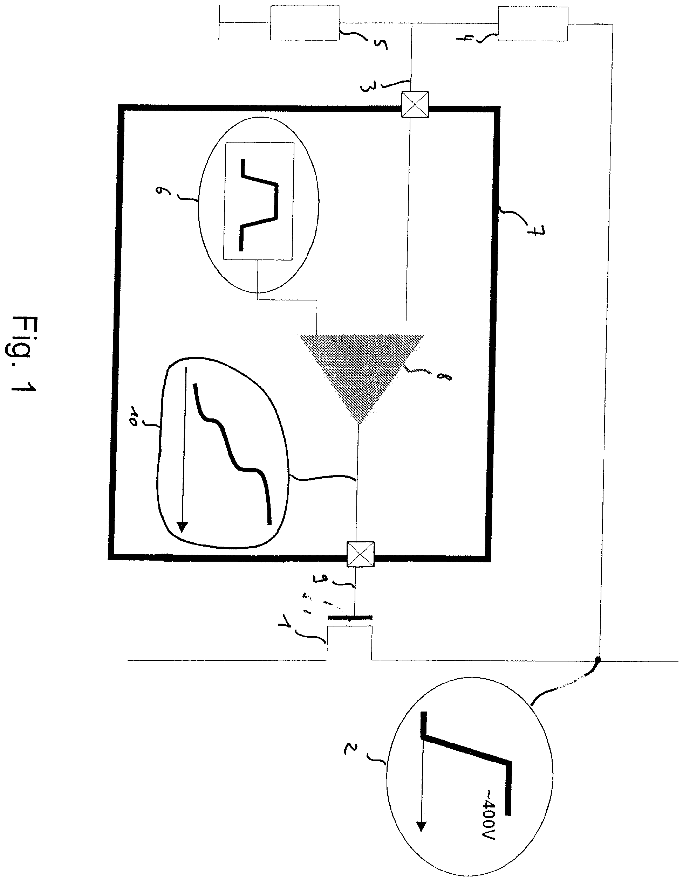

In Fig. 1 ist ein Leistungsschalter als FET-Transistor 1 ausgebildet. Dem Steuereingang (hier: Gate) 31 dieses Leistungsschalters 1 wird ein Ansteuersignal 9 von einer Regeleinrichtung zugeführt, die im vorliegenden Ausführungsbeispiel eine integrierte Schaltung (ASIC) 7 sein kann, beispielsweise aber auch als diskrete oder hybride Schaltung aufgebaut sein kann.

Mittels eines Spannungsteilers aufweisend Widerstände 4, 5 wird ein Parameter des Schaltverhaltens des Leistungsschalters 1 zumindest während eines Teils der Zeitdauer von Schaltvorgängen, insbesondere während der Flanken, erfaßt. Dieser Parameter kann beispielsweise der Strom I durch den Leistungsschalter 1 und/oder die Spannung *U* an dem Leistungsschalter 1 sein.

Wie bereits erwähnt kann die Messung/Regelung auf bestimmte zeitliche Abschnitte wie bspw. die dynamischen Bereiche (Flanken) begrenzt sein, aber auch kontinuierlich das Schaltverhalten anhand wenigstens eines Parameters überwachen, so dass auch die statischen Bereiche überwacht und geregelt werden.

Das Bezugszeichen 2 zeigt schematisch ein in dieser Weise gemessenes Istverhalten des Schaltverhaltens im Bereich einer ansteigenden Flanke, d.h. eines Einschaltvorgangs des Leistungsschalters 1. Im vorliegenden Beispiel wird die an dem Schalter 1 anliegende Spannung U gemessen und geregelt. Wie aus Fig. 1 ersichtlich ist das Istverhalten, das durch die erfindungsgemäße Regelschaltung optimiert ist, derart geregelt, daß die Flanke einen vorbestimmten Verlauf und insbesondere eine vorbestimmte endliche Flankensteilheit aufweist.

Es ist anzumerken, daß durch die erfindungsgemäße Regelschaltung auch andere Flankenverläufe und insbesondere nichtlinear verlaufende Flankenverläufe bei entsprechender Vorgabe (siehe weiter unten im Zusammenhang der Erläuterung des Bezugszeichens 6) erzielt werden können.

Der gemessene Parameter wird einem Eingang 3 der Regeleinrichtung (ASIC) 7 zugeführt. Die Regeleinrichtung 7 weist einen Komparator 8 auf, der das gemessene, an dem Eingang 3 zugeführte Istsignal mit einem extern oder im vorliegenden Beispiel intern vorgegebenen Sollverhalten 6 vergleicht und abhängig von diesem Vergleich zur Implementierung eines Regel-Algorithmus ein Korrektursignal als Ansteuersignal 9 an den Steuereingang des Leistungsschalters 1 abgibt.

Das Sollverhalten 6 kann in unterschiedlicher Weise, beispielsweise unter Zuhilfenahme eines Rechteck-Oszillators mit begrenzter Flankensteilheit, implementiert werden.

Die in Fig. 1 dargestellte Regelschaltung weist eine analoge Schaltung zur Implementierung des Sollverhaltens 6 auf. Dabei kann im Falle einer derartigen analogen Sollwertvorgabe ein kontinuierliches Sollverhalten auferlegt werden.

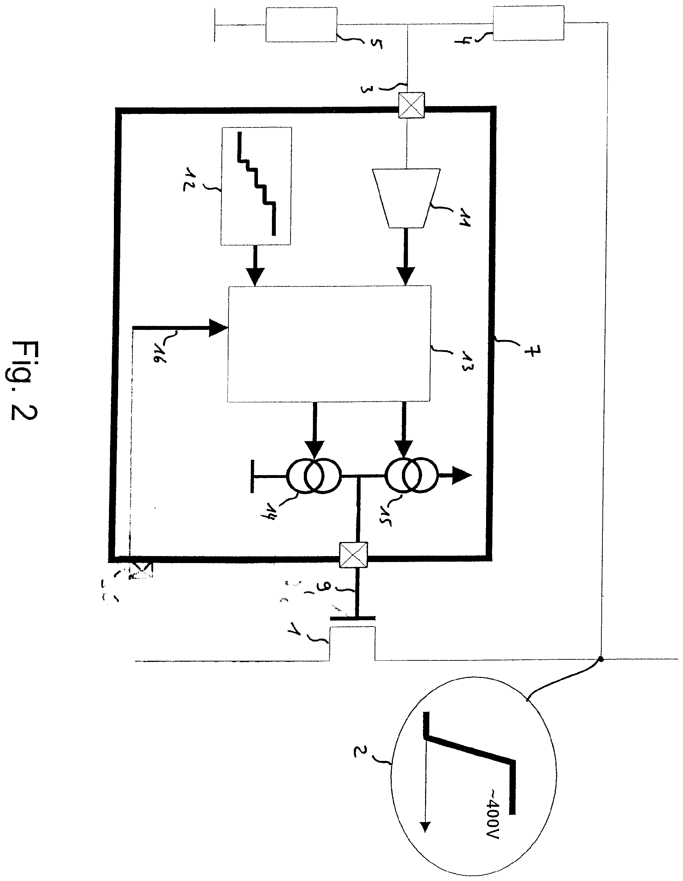

In Fig. 2 ist eine schematische Übersicht über eine digitale Ausführungsform der erfindungsgemäßen Regelschaltung gezeigt.

Wie in der analogen Ausführungsform der Fig. 1 wird ein Leistungsschalter 1 von einem Ansteuersignal 9 gespeist. Das Istverhalten eines Parameters des Leistungsschalters 9 - wie beispielsweise des Stroms und/oder der Spannung durch den bzw. an dem Leistungsschalter 9 - wird wiederum von einer Regeleinrichtung 7 mit Hilfe eines Spannungsteilers 4, 5 erfasst.

Die Funktion der Regeleinrichtung 7 besteht in einem Vergleich des gemessenen Istverhaltens mit einem vorgegebenen Sollverhalten 12 und in einer dementsprechenden Ansteuerung 9 des Leistungsschalters 9.

Der Vergleich der Ist- und Sollverhalten und die zeitliche Reaktion darauf wird von einer Logikschaltung 13 durchgeführt, die u.a. die Funktion eines digitalen Komparators enthält. Ein Analog-Digital-Wandler 11 zur Digitalisierung des erfassten Eingangs-Parameters 3 liefert der Logikschaltung 13 das entsprechende digitale Istverhalten. Die das Sollverhalten wiedergebenden diskreten Digitalwerte werden aus einem Speicher 12 einem weiteren Eingang der Logikschaltung 13 zugeführt.

Ein weiterer Eingang der Logikschaltung 13 dient als Steuereingang 16. Über den Steuereingang 16 lässt sich bspw. das dynamische Regelverhalten mittels Einstellung der zeitlichen Reaktion der Logikschaltung auf Regelabweichungen einstellen.

Eine Bereitstellung des Sollverhaltens mittels digitaler Werte in einem Speicher gemäss dem Ausführungsbeispiel von Figur 2 hat den Vorteil, daß im wesentlichen beliebige, auch nichtlineare Verläufe insbesondere im Bereich der Flanken für das Schaltverhalten vorgegeben werden können.

Minimal sind dabei für eine Flanke zwei diskrete Stützwerte in dem Speicher 12 abgelegt, wodurch bereits eine geradlinig verlaufende Flanke vorgegeben werden kann. Für komplexere Flankenverläufe oder aber auch zur Präzisierung derartiger geradliniger Flanken kann selbstverständlich die Anzahl der Stützwerte, die das Sollverhalten wiedergeben, beliebig erhöht werden.

Nachdem die Logikschaltung 13 der Regeleinrichtung 7 die Ist- und Sollverhalten in der Art eines Fehlerverstärkers ("Error Amplifier") verglichen hat, steuert er programmierbare Stromquellen 14, 15 derart an, dass der Leistungsschalter 1 mit dem gewünschten Ansteuersignal 9 betrieben wird, also das Istverhalten im wesentlichen dem Sollverhalten folgt.

Die gerade beschriebenen analogen und digitalen Ausführungsbeispiele betreffen also eine Ausführungsform, bei der eine geschlossene Regelschleife während des Betriebs des Leistungsschalters 1 die Ansteuerung korrekturmäßig nachregelt, um das Sollverhalten zu erreichen.

Indessen betrifft die vorliegende Erfindung auch die einmalige Kalibrierung einer Ansteuerschaltung, bei der ein bestehendes Schaltverhalten 2 des Leistungsschalters 1 einmalig mittels eines speziellen Messgeräts 18 erfasst wird und dann eine einmalige, bspw. werksseitige Kalibrierung der Ansteuerschaltung 7 durchgeführt wird.

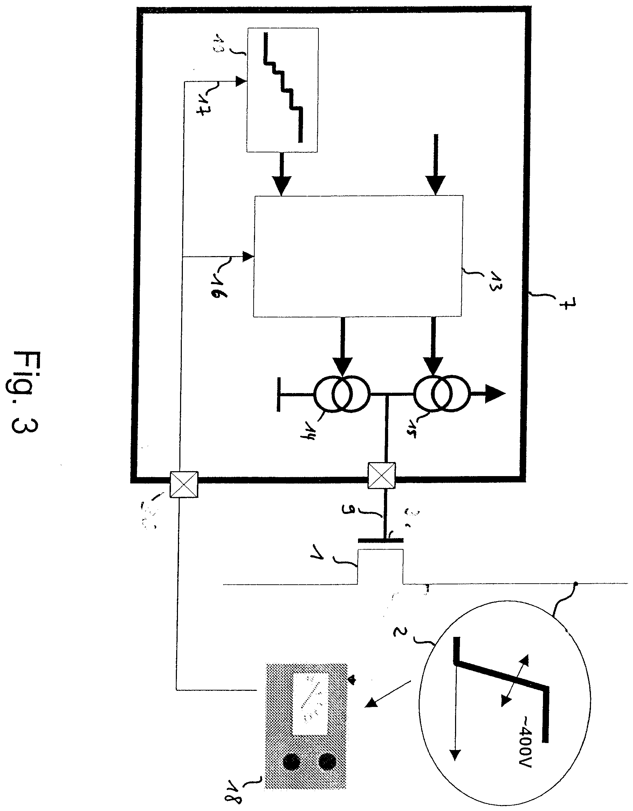

Dies ist schematisch in Fig. 3 dargestellt. Bei dieser Ausführungsform ist ein externer oder hier interner, programmierbarer Kalibrierspeicher 19 vorgesehen (bei den zuvor genannten Ausführungsbeispielen ist der Speicher 6 bzw. 12 nicht notwendigermassen programmierbar).

Beispielsweise bei der Fertigung wird also die Ansteuerschaltung 7 einmalig kalibriert, so daß dann im eigentlichen Betrieb des Leistungsschalters 1 eine Messung und eine geschlossene Regelschleife zur Verwertung des Meßergebnisses des Leistungsschalters-Parameters nicht erforderlich sind.

Die Messung und Kalibrierung kann indessen jederzeit, bspw. in fest vorgegebenen Abständen oder bei Auferlegung einer neuen Funktionalität erneut durchgeführt werden.

Die Kalibrierung kann dabei wie dargestellt durch interne Abspeicherung 19 von Kalibrierdaten erfolgen, die den zeitlichen Verlauf der Ansteuerung beeinflussen. Vorstellbar ist aber auch eine externe Kalibrierung über einen Trimmeingang etc. (nicht dargestellt).

Zur Kalibrierung wird also über ein Messgerät 18 das Schaltverhalten erfasst. Über einen Programmiereingang 30 der integrierten Schaltung 7 können dann die Werte des Kalibrierspeichers 19 (Programmierzugriff 17) und/oder das dynamische Verhalten ("Control Pattern")der Logikschaltung 13 eingestellt werden.

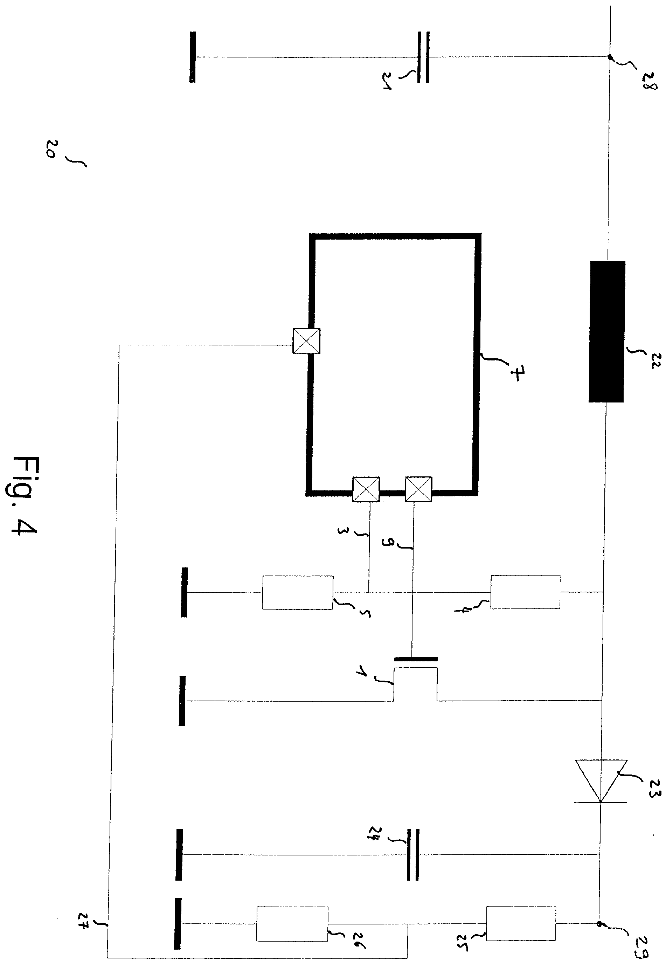

Fig. 4 zeigt schließlich, wie die erfindungsgemäße Technik bei einer PFC (Power Factor Correction)-Schaltung angewendet werden kann. In dem Ausführungsbeispiel von Fig. 4 wird beispielsweise die Spannung über dem Leistungsschalter 1 überwacht, um durch gezielte Ansteuerung des Schalters eine Verringerung durch hochfrequente Störungen zu erzielen.
Wie aus dem Stand der Technik grundsätzlich bekannt, wird die Eingangs-Spannung 28 einer PFC-Schaltung 20 von einem Glättungskondensator 21 gesiebt und einer Induktivität 22, i.e. einer Spule, zugeführt. Die Induktivität 22 wird mittels des Leistungsschalters 1 wahlweise geladen bzw. entladen. Die PFC-Schaltung 20 weist außerdem eine in Serie zu der Induktivität 22 geschaltete Diode 23 auf.
Wenn der Leistungsschalter 1 eingeschaltet ist, ist die Induktivität 22 gegen Masse kurzgeschlossen und die Diode 23 gesperrt. Die Induktivität 22 lädt sich dann auf, so dass Energie in der Induktivität 22 gespeichert wird.
Wenn der Leistungsschalter 1 hingegen ausgeschaltet ist, ist die Diode 23 leitend. Die Induktivität 22 entlädt sich dann über die Diode 23 in den Ausgangs-Kondensator 24. Die Energie wird dadurch an den Ausgangs-Kondensator 24 übertragen.
Der Spannungsteiler 4, 5 dient dazu, das Istverhalten des Stroms und/oder der Spannung durch den bzw. an dem Leistungsschalter 1 zu ermitteln 3. Mittels eines weiteren Spannungsteilers 25, 26 kann die Ausgangs-Spannung 29 gemessen werden 27.

Die im ASIC 7 vorgesehene Treiberschaltung für die Ansteuerung des Leistungsschalters 1 ist in den Figuren nicht dargestellt.

Durch die geschlossene Regelschleife bzw. die Kalibrierung können Toleranzen des Leistungsschalters 1 kompensiert werden, so daß stets im wesentlichen das gewünschte Sollverhalten erzielt werden kann. Somit kann beispielsweise dasselbe ASIC für verschiedene Leistungsstufen von Gasentladungslampen verwendet werden, die unterschiedlich dimensionierte Schalter benötigen. Insgesamt ergibt sich also ein geregeltes Schaltverhalten.

Bei der Kalibrierung kann sozusagen eine "Universal-Treiberschaltung" vorgesehen sein, die abhängig von der zuvor ausgeführten Messung des entsprechenden Parameters des Leistungsschalters auf den speziell verwendeten Leistungsschalter hin spezifiziert wird.

Liste der in den Figuren benutzten Bezugszeichen:

| | |
|---|---|
| 1 | Leistungsschalter, bspw. FET-Transistor |
| 2 | gemessenes Istverhalten des Stroms und/oder der Spannung durch den bzw. an dem Leistungsschalter |
| 3 | Eingang der Regeleinrichtung |
| 4 | Widerstand eines Spannungsteilers |
| 5 | Widerstand eines Spannungsteilers |
| 6 | analoges vorgegebenes Sollverhalten |
| 7 | Regeleinrichtung: integrierte Schaltung (ASIC), bzw. diskrete Schaltung |
| 8 | Komparator |
| 9 | Ansteuersignal des Leistungsschalters |
| 10 | Darstellung des Ansteuersignals |
| 11 | Analog-Digital-Wandler |
| 12 | digitales vorgegebenes Sollverhalten, bzw. digitaler Speicher |
| 13 | digitale Logikschaltung |
| 14 | Stromquelle |
| 15 | Stromquelle |
| 16 | Steuereingang |
| 17 | externe Abspeicherung von Kalibrierdaten |
| 18 | Messgerät |
| 19 | Kalibrierspeicher |
| 20 | PFC-Schaltung |
| 21 | Glättungskondensator |
| 22 | Induktivität |
| 23 | Diode |
| 24 | Ausgangs-Kondensator |
| 25 | Widerstand eines Spannungsteilers |
| 26 | Widerstand eines Spannungsteilers |
| 27 | gemessene Ausgangs-Spannung |
| 28 | Eingangs-Spannung |
| 29 | Ausgangs-Spannung |

## Patentansprüche

1. Verfahren zur Kalibrierung des Schaltverhaltens eines Leistungsschalters eines PFC eines Betriebsgeräts für Leuchtelemente,
aufweisend die folgenden Schritte:
- Messung des Stroms und/oder der Spannung durch den bzw. an dem Leistungsschalter (1) zumindest für einen zeitlichen Abschnitt eines Schaltvorgangs, und
- Abgleich der Ansteuerung des Leistungsschalters (1) derart, dass das tatsächliche Schaltverhalten im wesentlichen einem vorgegebenen Sollverhalten entspricht,
- wobei das Sollverhalten den Flankenverlauf des Schaltvorgangs vorgibt.

2. Verfahren nach Anspruch 1,
**dadurch gekennzeichnet,**
**dass** das Sollverhalten programmiert wird.

3. Verfahren nach einem der vorhergehenden Ansprüche,
**dadurch gekennzeichnet,**
**dass** das Sollverhalten anhand wenigstens zweier Stützpunkte vorgegeben wird.

4. Verfahren nach einem der vorhergehenden Ansprüche,
**dadurch gekennzeichnet,**
**dass** Werte, die das Sollverhalten wiedergeben, in einem Speicher (6) abgelegt sind und/oder mittels einer analogen Schaltung bereitgestellt werden.

5. Verfahren nach einem der vorhergehenden Ansprüche,
**dadurch gekennzeichnet,**
**dass** die Dynamik des Regelverhaltens einstellbar ist.

6. Verwendung eines Verfahrens gemäss einem der vorhergehenden Ansprüche in einer PFC-Schaltung.

7. System zur Kalibrierung des Schaltverhaltens eines Leistungsschalters eines PFC eines Betriebsgeräts für Leuchtmittel,
aufweisend:
- Mittel (18) zur Messung des Stroms und/oder der Spannung durch den bzw. an dem Leistungsschalter zumindest für einen zeitlichen Abschnitt eines Schaltvorgangs, und
- Mittel (16, 17, 19) zum Abgleich der Ansteuerung des Leistungsschalters derart, dass das tatsächliche Schaltverhalten im wesentlichen einem vorgegebenen Sollverhalten entspricht,
- wobei das Sollverhalten den Flankenverlauf des Schaltvorgangs vorgibt.

8. Betriebsgerät für Leuchtelemente, aufweisend eine Leistungsschalter-Regelschaltung eines PFC eines derartigen Betriebsgeräts,
**dadurch gekennzeichnet, dass**
die Leistungsschalter-Regelschaltung folgende Mittel aufweist:
- Mittel (6) zur Vorgabe eines Sollverhaltens des Stroms und/oder der Spannung durch einen bzw. an einem Leistungsschalter (1) des PFCs des Betriebsgeräts, zumindest für einen zeitlichen Abschnitt eines Schaltvorgangs,
- Mittel zur Messung (4, 5) und Rückführung (3) des Istverhaltens des Stroms und/oder der Spannung durch den bzw. an dem Leistungsschalter (1) während eines Schaltvorgangs, und
- Mittel zur Regelung der Ansteuerung (9) des Leistungsschalters derart, dass das Istverhalten im wesentlichen dem Sollverhalten entspricht.

9. Betriebsgerät nach Anspruch 8,
**dadurch gekennzeichnet,**
**dass** die Dynamik des Regelungsverhaltens der Regelungsmittel einstellbar (30) ist.

10. Betriebsgerät nach Anspruch 8 oder 9,
**dadurch gekennzeichnet,**
**dass** die Mittel zur Regelung ein ASIC aufweisen.

11. Betriebsgerät nach Anspruch 9 oder 10,
**dadurch gekennzeichnet,**
**dass** die Mittel zur Regelung eine diskrete Schaltung aufweisen.

12. Betriebsgerät nach einem der Ansprüche 8 bis 11,
**dadurch gekennzeichnet,**
**dass** Werte, die das Sollverhalten wiedergeben, in einem Speicher abgelegt sind.

13. Betriebsgerät nach einem der Ansprüche 8 bis 12,
**dadurch gekennzeichnet,**
**dass** die Sollwertvorgabe mittels einer analogen Schaltung erfolgt.

14. Betriebsgerät nach Anspruch 13,
**dadurch gekennzeichnet,**
**dass** die analoge Schaltung einen Rechteck-Oszillator mit begrenzter Flankensteilheit aufweist.

## Claims

1. A method for calibrating the switching behavior of a power switch of a PFC of an operating device for luminous elements,
having the following steps:
- Measurement of the current and/or the voltage through the or at the power switch (1) at least for a time period of a switching operation, and
- adjustment of the control of the power switch (1) in such a manner that the actual switching behavior corresponds substantially to a predetermined target behavior,
- wherein the target behavior specifies the edge profile of the switching operation.

2. A method according to Claim 1,
**characterized in**
**that** the target behavior is programmed.

3. A method according to any one of the preceding claims,
**characterized in**
**that** the target behavior is predetermined by means of at least two supporting points.

4. A method according to any one of the preceding claims,
**characterized in**
**that** values, which reflect the target behavior, are stored in a memory (6) and/or are provided by means of an analog circuit.

5. A method according to any one of the preceding claims,
**characterized in**
**that** the dynamics of the control behavior is adjustable.

6. A use of a method according to any one of the preceding claims in a PFC circuit.

7. A system for calibrating the switching behavior of a power switch of a PFC of an operating device for luminous means,
having:
- means (18) for the measurement of the current and/or the voltage through the or at the power switch at least for a time period of a switching operation, and
- means (16, 17, 19) for the adjustment of the control of the power switch in such a manner that the actual switching behavior corresponds substantially to a predetermined target behavior,
- wherein the target behavior specifies the edge profile of the switching operation.

8. An operating device for luminous elements, having a power switch-control circuit of a PFC of such an operating device,
**characterized in that**
the power switch-control circuit has the following means:
- Means (6) for specifying a target behavior of the current and/or the voltage through a or at a power switch (1) of the PFC of the operating device, at least for a time period of a switching operation,
- means for the measurement (4, 5) and feedback (3) of the actual behavior of the current and/or the voltage through the or at the power switch (1) during a switching operation, and
- means for controlling the control (9) of the power switch in such a manner, that the actual behavior corresponds substantially to the target behavior.

9. An operating device according to Claim 8,
**characterized in**
**that** the dynamics of the control behavior of the control means is adjustable (30).

10. An operating device according to Claim 8 or 9,
**characterized in**
**that** the means for the controlling have an ASIC.

11. An operating device according to Claim 9 or 10,
**characterized in**
**that** the means for the controlling have a discrete circuit.

12. An operating device according to any one of Claims 8 to 11,
**characterized in**
**that** values, which reflect the target behavior, are stored in a memory.

13. An operating device according to any one of Claims 8 to 12,
**characterized in**
**that** the target value specification is made by means of an analog circuit.

14. An operating device according to Claim 13,
**characterized in**
**that** the analog circuit has a square-wave oscillator with limited edge steepness.

## Revendications

1. Procédé de calibrage du comportement de commutation d'un disjoncteur d'un PFC d'un dispositif de commande pour des éléments d'éclairage, comprenant les étapes suivantes :
- mesure du courant et/ou de la tension à travers ou appliqué au disjoncteur (1) au moins pendant un intervalle de temps d'un processus de commutation et
- ajustement de la commande du disjoncteur (1) de façon à ce que le comportement de commutation réel corresponde globalement à un comportement de consigne prédéterminé,
- le comportement de consigne déterminant le tracé des flancs du processus de commutation.

2. Procédé selon la revendication 1,
**caractérisé en ce que**
le comportement de consigne est programmé.

3. Procédé selon l'une des revendications précédentes,
**caractérisé en ce que**
le comportement de consigne est prédéterminé à l'aide d'au moins deux points d'appui.

4. Procédé selon l'une des revendications précédentes,
**caractérisé en ce que**
les valeurs qui représentent le comportement de consigne sont enregistrées dans une mémoire (6) et/ou sont mises en disposition au moyen d'un circuit analogique.

5. Procédé selon l'une des revendications précédentes,
**caractérisé en ce que**
la dynamique du comportement de régulation est réglable.

6. Utilisation d'un procédé selon l'une des revendications précédentes dans un circuit PFC.

7. Système de calibrage du comportement de commutation d'un disjoncteur d'un PFC d'un dispositif de commande d'un moyen d'éclairage, comprenant :
- des moyens (18) pour la mesure du courant et/ou de la tension à travers ou appliquée au disjoncteur pendant au moins un intervalle de temps d'un processus de commutation et
- des moyens (16, 17, 19) pour l'ajustement de la commande du disjoncteur de façon à ce que le comportement de consigne corresponde globalement à un comportement de consigne prédéterminé,
- le comportement de consigne déterminant le tracé des flancs du processus de commutation.

8. Dispositif de commande pour éléments d'éclairage comprenant un circuit de régulation de disjoncteur d'un PFC d'un tel dispositif de commande, **caractérisé en ce que** le circuit de régulation de disjoncteur comprend les moyens suivants :
- des moyens (6) pour la prédétermination d'un comportement de consigne du courant et/ou de la tension à travers ou appliquée à un disjoncteur (1) du PFC du dispositif de commande, au moins pendant un intervalle de temps d'un processus de commutation,
- des moyens pour la mesure (4, 5) et le retour (3) du comportement réel du courant et/ou de la tension à travers ou appliquée au disjoncteur (1) pendant un processus de commutation et
- des moyens pour la régulation de la commande (9) du disjoncteur de façon à ce que le comportement réel corresponde globalement au comportement de consigne.

9. Dispositif de commande selon la revendication 8,
**caractérisé en ce que**
la dynamique du comportement de régulation des moyens de régulation est réglable (30).

10. Dispositif de commande selon la revendication 8 ou 9,
**caractérisé en ce que**
les moyens de régulation comprennent un ASIC.

11. Dispositif de commande selon la revendication 9 ou 10,
**caractérisé en ce que**
les moyens de régulation comprennent un circuit discret.

12. Dispositif de commande selon l'une des revendications 8 à 11,
**caractérisé en ce que**
les valeurs qui représentent le comportement de consigne sont enregistrées dans une mémoire.

13. Dispositif de commande selon l'une des revendications 8 à 12,
**caractérisé en ce que**
la prédétermination des valeurs de consigne a lieu au moyen d'un circuit analogique.

14. Dispositif de commande selon la revendication 13,
**caractérisé en ce que**
le circuit analogique comprend un oscillateur rectangulaire avec une pente de flancs limitée.
